# EUROPÄISCHE PATENTSCHRIFT

(11) **EP 2 125 607 B1**
(45) Veröffentlichungstag und Bekanntmachung des Hinweises auf die Patenterteilung: **29.02.2012**
(21) Anmeldenummer: 07847470.7
(22) Anmeldetag: 28.11.2007
(51) Int. Cl.: B81C 1/00, G01L 9/00

(54) **Sensorelement zur Relativdruckmessung und Herstellungsverfahren**
Sensor element for measuring relative pressure and method of manufacture
Élément détecteur de pression relative et méthode de fabrication

(30) Priorität: 24.01.2007 DE 102007003544
(43) Veröffentlichungstag der Anmeldung: 02.12.2009
(73) Patentinhaber: Robert Bosch GmbH, 70442 Stuttgart (DE)
(72) Erfinder: KRAMER, Torsten, 72827 Wannweil (DE); KNESE, Kathrin, 70374 Stuttgart (DE); BENZEL, Hubert, 72124 Pliezhausen (DE); SCHUERMANN, Gregor, 70619 Stuttgart (DE); ARMBRUSTER, Simon, 72810 Gomaringen (DE); SCHELLING, Christoph, 70597 Stuttgart (DE)
(86) Internationale Anmeldenummer: PCT/EP2007/062952
(87) Internationale Veröffentlichungsnummer: WO 2008/089862

(56) Entgegenhaltungen:
- EP-A- 1 712 515
- DE-A1- 10 032 579
- DE-A1-102004 015 444
- US-B1- 6 787 052

## Beschreibung

### Stand der Technik

Die Erfindung betrifft ein Verfahren zur Herstellung eines Bauteils mit mindestens einer in der Bauteiloberfläche ausgebildeten Membran, die eine Kaverne überspannt, und mit mindestens einer von der Bauteilrückseite ausgehenden Zugangsöffnung zu der Kaverne, wobei zumindest eine erste Membranschicht und die Kaverne von der Bauteiloberfläche ausgehend in einem monolithischen Halbleitersubstrat erzeugt werden und wobei die Zugangsöffnung von der Substratrückseite ausgehend in einem zeitlich begrenzten Ätzschritt erzeugt wird.

Des Weiteren betrifft die Erfindung ein derartiges Bauteil, das als Sensorelement zur Relativdruckmessung eingesetzt wird.

Es ist bekannt, mikromechanische Sensorelemente mit Membranen zur Relativdruckmessung einzusetzen. Für diese Anwendung muss die Membran, die meist in der Bauteiloberfläche ausgebildet ist, beidseitig zugänglich sein. In der Praxis wird die Membran derartiger mikromechanischer Sensorelemente deshalb häufig von der Waferrückseite ausgehend freigelegt. Dazu werden volumenmikromechanische Verfahren eingesetzt, wie z.B. KOH-Ätzen, wobei relativ große Ausnehmungen entstehen, die für die Größe des Sensorelements mitbestimmend sind.

In den deutschen Patentanmeldungen DE 100 32 579 A1, DE 10 2004 036 035 A1 und DE 10 2004 036 032 A1 werden Verfahren beschrieben, die auch unter dem Begriff APSM (Advanced Porous Silicon Membrane)-Technologie bekannt sind. Mit diesen Verfahren können beispielsweise Sensorelemente zur Absolutdruckmessung mit sehr kleiner Chipfläche und sehr genauen Herstellungstoleranzen gefertigt werden. Diese Verfahren lassen sich relativ einfach realisieren und sind dementsprechend kostengünstig. Da die APSM-Technologie außerdem CMOS-kompatibel ist, lassen sich auch Schaltungselemente einer Auswerteschaltung und insbesondere Widerstände zur piezoresistiven Signalerfassung einfach auf dem Sensorelement integrieren.

Gemäß dem aus der DE 100 32 579 A1 bekannten Verfahren wird mit Hilfe eines Ätzmediums, das die unmaskierten Oberflächenbereiche eines monolithischen Siliziumsubstrats angereift, ein erster poröser Schichtbereich im Substrat erzeugt, der an die Substratoberfläche angrenzt. Die Ausdehnungsgeschwindigkeit der Poren lässt sich durch Anlegen eines elektrischen Feldes zwischen der Oberseite und der Unterseite des Substrats und durch geeignete Einstellung der elektrischen Feldstärke während des Ätzangriffs beeinflussen. Durch Erhöhen der elektrischen Feldstärke wird unterhalb des ersten Schichtbereichs ein zweiter poröser Schichtbereich erzeugt, dessen Porosität größer ist als die Porosität des ersten Schichtbereichs. In einem anschließenden Temperschritt ordnen sich die Poren im zweiten Schichtbereich so um, dass eine einzige große Pore, d.h. eine Kaverne, unterhalb des ersten Schichtbereichs entsteht. Zumindest die Poren auf der Oberseite des ersten Schichtbereichs werden durch die Temperung weitgehend verschlossen. Dadurch ist es möglich, auf diesem ersten Schichtbereich eine weitgehend monokristalline Siliziumschicht als Membranschicht abzuscheiden, in die dann einfach elektrische Schaltungselemente, wie z.B. Widerstände, zur Signalerfassung und -auswertung integriert werden können.

Gemäß den aus der DE 10 2004 036 035 A1 und DE 10 2004 036 032 A1 bekannten Verfahren wird in einem Halbleiterträger ein erster Bereich mit einer ersten Dotierung erzeugt, der die Kaverne unter der zu erzeugenden Membran bilden soll. Über diesem ersten Bereich wird ein gitterförmiger Bereich mit einer zweiten Dotierung erzeugt, der als Stabilisierungselement für die zu erzeugenden Membran dient. In einer ersten Verfahrensvariante wird dann der erste Bereich durch die Gitteröffnungen des Stabilisierungselements hoch porös geätzt. Aufgrund der unterschiedlichen Dotierungen wird das Stabilisierungselement dabei praktisch nicht angegriffen. Danach wird der Halbleiterträger mit einer Epitaxieschicht versehen. Diese wächst im Wesentlichen auf der Gitterstruktur des Stabilisierungselements auf, wobei das Wachstum sowohl in vertikaler als auch in lateraler Richtung erfolgt, so dass sich die Gitteröffnungen schließen. Das hoch poröse Halbleitermaterial des ersten Bereichs lagert sich während dem Aufwachsvorgang oder während eines Temperschritts zu einer großen Pore bzw. einer Kaverne unter der idealerweise monokristallinen Epitaxieschicht um, die dann als Membranschicht fungiert. In einer zweiten Verfahrensvariante wird das Halbleitermaterial des ersten Bereichs noch vor dem Erzeugen der Epitaxieschicht vollständig herausgelöst.

Da die an die Kaverne angrenzenden Membranschichten hier oftmals prozessbedingt aus demselben Material bestehen wie das Substrat, nämlich aus monokristallinem Silizium, erweist sich eine nachträgliche Strukturierung der Substratrückseite zum Erzeugen einer Zugangsöffnung zur Kaverne als problematisch. In diesem Fall sind besondere Maßnahmen zum Schutz der Membranstruktur erforderlich.

Die US 2006/0260408 A1 beschäftigt sich mit dieser Problematik. Hier wird unter anderem vorgeschlagen, den von der Substratrückseite ausgehenden Ätzangriff zeitlich zu begrenzen, und zwar so, dass eine Zugangsöffnung zur Kaverne erzeugt wird, die darüber liegende Membranstruktur aber möglichst nicht angegriffen wird.

In der Praxis hat sich gezeigt, dass eine derartige zeitliche Begrenzung des rückseitigen Ätzangriffs kritisch ist und deshalb nicht ohne weiteres für eine Massenproduktion geeignet ist. Ein Grund dafür ist, dass die Dicke der Membranstruktur und die Ausdehnung der Kaverne gering sind im Vergleich zur Substratdicke. Hinzu kommt, dass die Dicke der Membranstruktur im Bereich der Dickenschwankungen liegt, mit denen die üblicherweise als Substratmaterial verwendeten Wafer gefertigt werden. Insgesamt ist die zeitliche Begrenzung des rückseitigen Ätzangriffs deshalb sehr sensibel.

### Offenbarung der Erfindung

Mit der vorliegenden Erfindung werden einfache Maßnahmen vorgeschlagen, die eine nachträgliche Rückseitenprozessierung von Bauteilen mit einer Membranstruktur in der Bauteiloberfläche ermöglichen, um Zugangsöffnungen zu der Kaverne unterhalb der Membran zu erzeugen.

Erfindungsgemäß wird die Zugangsöffnung in einem Bereich angeordnet, in dem das Substratmaterial an die erste Membranschicht heranreicht. Der Ätzprozess zum Erzeugen der Zugangsöffnung umfasst mindestens einen anisotropen Ätzschritt und mindestens einen isotropen Ätzschritt. In dem anisotropen Ätzschritt wird ein von der Substratrückseite ausgehender Ätzkanal erzeugt, der unterhalb der ersten Membranschicht in der Umgebung der Kaverne endet. Zumindest der Endbereich dieses Ätzkanals wird dann in dem isotropen Ätzschritt aufgeweitet, bis der Ätzkanal an die Kaverne angeschlossen ist.

Im Rahmen des beanspruchten Verfahrens wird der Ätzstopp bei der Erzeugung der rückwärtigen Zugangsöffnung ohne zusätzliche Ätzstoppschichten sondern einfach durch zeitliche Begrenzung des Ätzprozesses realisiert. Erfindungsgemäß ist nämlich erkannt worden, dass die Dauer des Ätzprozesses nicht exakt auf die Dicke des Substrats im Bereich unter der Kaverne eingestellt werden muss, sondern dass sich durch geschicktes Anordnen der Zugangsöffnung in Kombination mit einem zweistufigen Ätzprozess eine den Herstellungsprozess wesentlich vereinfachende Herstellungstoleranz ergibt. Erfindungsgemäß wird die Zugangsöffnung in einem Bereich angeordnet, in dem das Substratmaterial an die erste Membranschicht heranreicht. Der Ätzkanal, der in einem ersten anisotropen Ätzschritt erzeugt wird, mündet also nicht direkt in der Kaverne, sondern endet unterhalb der ersten Membranschicht in der Umgebung der Kaverne. D.h., die Dauer dieses anisotropen Ätzschritts muss lediglich so bemessen sein, dass das Ende des Ätzkanals in einem Bereich liegt, der in etwa der vertikalen Abmessung der Kaverne entspricht. Erst durch den anschließenden isotropen Ätzschritt wird eine Verbindung zwischen dem Ätzkanal und der Kaverne hergestellt. Die Dauer dieses Ätzschritts muss zwar auf die Lage und Tiefe des Ätzkanals abgestimmt werden, ist aber nicht so kritisch wie im Fall des anisotropen Ätzangriffs. Durch die erfindungsgemäßen Maßnahmen wird das Herstellungsverfahren insgesamt robuster. So kann die Dauer des Ätzprozesses beispielsweise unabhängig von Dickenschwankungen des Substrats bemessen werden, solange sich diese Dickenschwankungen im üblichen Rahmen bewegen.

Grundsätzlich gibt es verschiedene Möglichkeiten für die Realisierung des erfindungsgemäßen Verfahrens, was die Anordnung der Zugangsöffnungen betrifft. So kann eine Zugangsöffnung beispielsweise im äußeren Randbereich der Kaverne angeordnet werden, um die mechanischen Eigenschaften der Membran möglichst wenig zu beeinflussen. In einer vorteilhaften Weiterbildung der Erfindung wird die Kaverne durch einen Hohlraum gebildet, an den sich eine unter der ersten Membranschicht verlaufende Stichleitung für den rückwärtigen Druckanschluss anschließt. In diesem Fall dient der Membranbereich über dem Hohlraum zur Messwerterfassung. Die Zugangsöffnung wird dann im Bereich der Stichleitung angeordnet, um die mechanischen Eigenschaften der Membran im Bereich über dem Hohlraum so wenig wie möglich zu beeinträchtigen. In einer weiteren vorteilhaften Variante der Erfindung wird die Zugangsöffnung im Bereich einer Stützstelle der Membran erzeugt, die innerhalb der Kaverne ausgebildet wird. Durch die Stützstelle wird die Membran während des Herstellungsprozesses unterstützt und stabilisiert.

Das erfindungsgemäße Verfahren geht davon aus, dass die Membranstruktur von der Bauteiloberfläche ausgehend im Substratmaterial erzeugt wird. Dies kann auf unterschiedliche Art und Weise erfolgen. Besonders vorteilhaft ist es, die voranstehend beschriebene APSM-Technologie zum Erzeugen der Membranstruktur anzuwenden.

Demnach wird in einer Verfahrensvariante zunächst ein erster poröser Schichtbereich in einem Substrat erzeugt. Dann wird unter dem ersten porösen Schichtbereich ein zweiter poröser Schichtbereich im Substrat erzeugt, wobei die Porosität des zweiten Schichtbereichs größer ist als die Porosität des ersten Schichtbereichs. In einem nachfolgenden Temperschritt wird der zweite Schichtbereich in einen Hohlraum bzw. eine Kaverne umgewandelt. Bei diesem Temperschritt verschließen sich die Poren des erste Schichtbereichs zumindest weitgehend, so dass dieser erste Schichtbereich eine erste Membranschicht über der Kaverne bildet.

In einer weiteren Variante des erfindungsgemäßen Verfahrens wird ein poröser Schichtbereich im Substrat erzeugt, über dem dann eine Epitaxieschicht aus dem Substratmaterial abgeschieden wird. In einem anschließenden Temperschritt wird der poröse Schichtbereich in eine Kaverne umgewandelt, so dass die Epitaxieschicht eine erste Membranschicht über der Kaverne bildet.

In einer besonders vorteilhaften Verfahrensvariante wird ein erster Schichtbereich mit einer ersten Dotierung in einem Halbleitersubstrat erzeugt. Über diesem ersten Schichtbereich wird ein vorzugsweise gitterförmiger Stabilisierungsbereich mit mindestens einer Öffnung erzeugt, wobei sich die Dotierung des Stabilisierungsbereichs von der des ersten Schichtbereichs unterscheidet. Der erste Schichtbereich wird dann porös geätzt, bevor über dem Stabilisierungsbereich eine Epitaxieschicht erzeugt wird. Durch eine Temperaturbehandlung wird der poröse erste Schichtbereich schließlich in eine Kaverne umgewandelt, so dass die Epitaxieschicht eine erste Membranschicht über der Kaverne bildet. Diese Verfahrensvariante kann dahingehend modifiziert werden, dass das Halbleitermaterial des ersten Schichtbereichs nicht nur porös geätzt wird, sondern bereits vor dem Erzeugen der Epitaxieschicht herausgelöst wird, so dass eine Kaverne unter dem Stabilisierungsbereich entsteht.

Die erfindungsgemäßen Maßnahmen - nämlich die spezielle Anordnung der rückseitigen Zugangsöffnung in Verbindung mit einem zweistufigen, zeitlich begrenzten Ätzprozess zum Erzeugen dieser Zugangsöffnung - ermöglichen die Herstellung von Sensorelementen zur Relativdruckmessung in APSM-Technologie mit sämtlichen Vorteilen, die der Einsatz dieser Technologie mit sich bringt. So lassen sich in APSM-Technologie Sensorelemente mit beliebiger Membrangeometrie bei sehr geringer Chipgröße und sehr genauen Herstellungstoleranzen realisieren. Das Herstellungsverfahren ist zudem CMOS-kompatibel, d.h. es besteht die Möglichkeit der monolithischen Integration von Schaltungselementen einer Auswerteschaltung auf dem Sensorelement. Der Einsatz der APSM-Technologie im Rahmen des erfindungsgemäßen Verfahrens ist auch im Hinblick auf die Herstellungskosten der Sensorelemente vorteilhaft, da ein kostengünstiges Ausgangsmaterial, nämlich ein Siliziumsubstrat, verwendet werden kann, das einfach mit Hilfe von üblichen, gut handhabbaren und kontrollierbaren Halbleiterverfahren prozessiert werden kann.

Von besonderem Vorteil ist es, wenn im ersten Ätzschritt zur Strukturierung der Bauteilrückseite ein Trenchverfahren zum Einsatz kommt. Dadurch lassen sich auch bei größerer Substratdicke gezielt Zugangsöffnungen mit einer relativ kleinen Querschnittsfläche erzeugen, was im Hinblick auf die zunehmende Miniaturisierung mikromechanischer Bauelemente vorteilhaft ist.

### Kurze Beschreibung der Zeichnungen

Wie bereits voranstehend erörtert, gibt es verschiedene Möglichkeiten, die Lehre der vorliegenden Erfindung in vorteilhafter Weise auszugestalten und weiterzubilden. Dazu wird einerseits auf die Patentansprüche und andererseits auf die nachfolgende Beschreibung eines Ausführungsbeispiels der Erfindung anhand der Zeichnungen verwiesen.

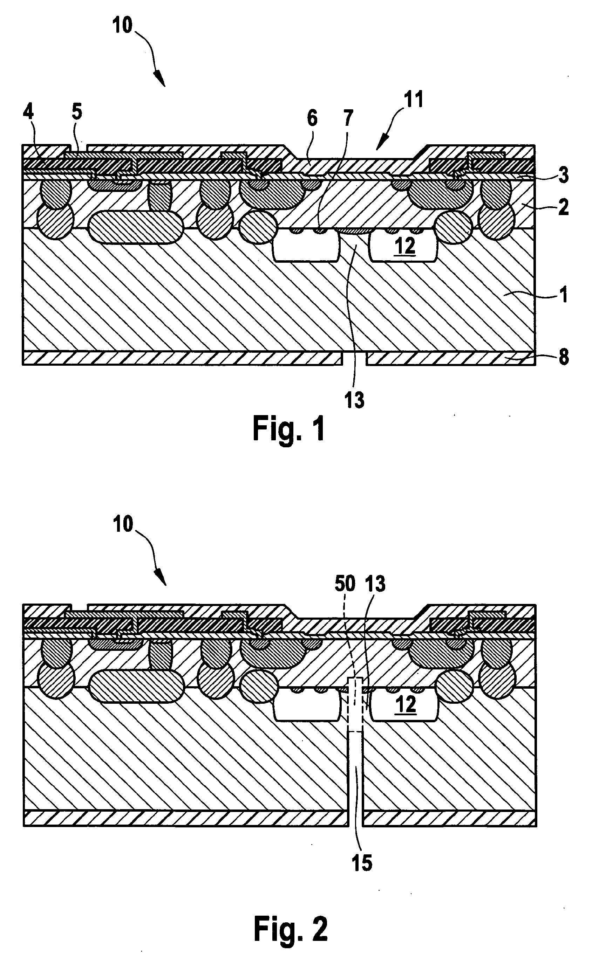

Die Figuren 1 bis 4 zeigen einen schematischen Querschnitt durch ein Sensorelement in verschiedenen Stadien des Herstellungsverfahrens.

### Ausführungsform der Erfindung

Bei dem in den Figuren 1 bis 4 dargestellten Sensorelement 10 handelt es sich um einen piezoresistiven Relativdrucksensor mit integrierter Auswerteschaltung, dessen mikromechanische Struktur eine Membran 11 umfasst, die in der Bauteiloberfläche ausgebildet ist und eine Kaverne 12 in einem Substrat 1 überspannt. Dabei kann es sich beispielsweise um einen Siliziumwafer handeln.

**Fig. 1** zeigt das Sensorelement 10, nachdem die Kaverne 12 in einem APSM-Prozess von der Bauteiloberfläche ausgehend erzeugt worden ist. Im hier dargestellten Ausführungsbeispiel wurde dabei auch eine Stützstelle 13 innerhalb des Membranbereichs erzeugt, an der die Membran 11 noch mit dem Bulkmaterial des Substrats 1 in Verbindung steht. Dazu wurde die Maske für den APSM-Prozess entsprechend ausgelegt. Durch geeignetes Layout und geeignete Dotierung eines n-Gitters 7 im Bereich der Kaverne 12 wurde der Bereich der Stützstelle 13 während der Anodisierung des APSM-Prozesses nicht porös geätzt. In diesem APSM-Prozess hat sich über der Kaverne 12 eine erste Membranschicht aus Substratmaterial gebildet, die durch eine n-Epitaxieschicht 2 auf dem Siliziumsubstrat 1 verstärkt wurde.

Nach dieser mikromechanischen Prozessierung des Substrats 1 erfolgte die Integration von Schaltungselementen, die in Form von dotierten Bereichen in der n-Epitaxieschicht 2 und dem Substrat 1 realisiert sind, in den Figuren aber nicht im einzelnen bezeichnet sind. Dann wurde eine Kontaktschicht 3 auf die n-Epitaxieschicht 2 aufgebracht. Des Weiteren umfasst die Auswerteschaltung metallische Leiterbahnen bzw. Leitungsschichten 5, die durch ein Zwischendielektrikum 4 gegeneinander isoliert sind. Schließlich wurde die gesamte Bauteiloberfläche noch mit einer Passivierung 6 versehen.

In einem nächsten Schritt wurde eine Maskierschicht 8 für einen von der Substratrückseite ausgehenden Trenchprozess auf die Rückseite des Substrats 1 aufgebracht. Durch Strukturierung der Maskierschicht 8 wurden dann die Lage, die Form und die Größe, genauer die Querschnittsfläche, des zu erzeugenden Ätzkanals 15 so definiert, dass er sich unter Berücksichtigung aller lateralen Toleranzen innerhalb der Stützstelle 13 ausbildet. Als Maskierschicht 2 kann beispielsweise eine geeignete Fotolackschicht oder auch eine sogenannte "Hardmask", z.B. aus Si-Oxid, verwendet werden.

**Fig. 2** zeigt das Sensorelement 10 nach dem Trenchprozess, bei dem ein von der Bauteilrückseite ausgehender Ätzkanal 15 entstanden ist, der sich innerhalb der Stützstelle 13 bis in den Bereich der Kaverne 12 erstreckt. Die Tiefe des Ätzkanals 15 wurde durch die Dauer des Trenchprozesses bestimmt. Der in Fig. 2 mit 50 bezeichnete Bereich des Ätzkanals 15 stellt den vertikalen Toleranzbereich für die Trenchtiefe dar. Die Untergrenze der Trenchtiefe liegt etwa auf dem Niveau des Kavernenbodens, die Obergrenze liegt etwa auf dem Niveau der Kavernendecke. Eine Ätzstoppschicht ist dank dieses Toleranzbereichs 50 nicht erforderlich. Durch die Anordnung des Ätzkanals 15 im Bereich der Stützstelle 13 können die Trenchtoleranzen sowohl in der Breite als auch in der Tiefe aufgefangen werden.

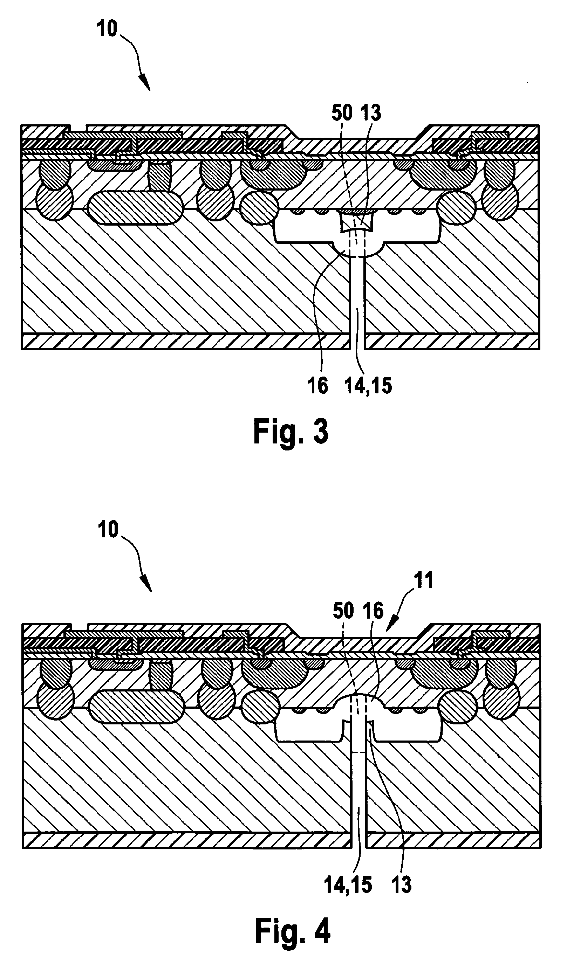

Während des Trechprozesses, der den ersten anisotropen Ätzschritt des erfindungsgemäßen Verfahrens bildet, wird ständig zwischen einem isotropen Ätzangriff und einer Seitenwandpassivierung hin und her geschaltet. Dabei wird die Passivierschicht am Boden durchgeätzt, bleibt jedoch an der Wandung bestehen, so dass der Ätzkanal 15 mit einem sehr hohen Aspektverhältnis realisiert werden kann. Im Anschluss an den Trenchprozess wird ein ebenfalls von der Bauteilrückseite ausgehender isotroper Ätzschritt durchgeführt. Dazu kann beispielsweise einfach der letzte isotrope Ätzangriff des Trenchprozesses verlängert werden. Alternativen dazu sind beispielsweise ein isotroper Ätzschritt mit ClF3 oder ein Nassätzschritt. Bei dem isotropen Ätzschritt erweitert sich der Endbereich 16 des Ätzkanals 15 blasenartig. Dieser Ätzangriff wird so lange fortgesetzt, bis der Ätzkanal 15 mit seinem Endbereich 16 eine Zugangsöffnung 14 zur Kaverne 12 bildet, was in den **Figuren 3 und 4** dargestellt ist. Fig. 3 zeigt einen Ätzkanal 15, dessen Endbereich 16 auf dem Niveau des Kavernenbodens liegt, also an der Untergrenze des Toleranzbereichs 50, und Fig. 4 zeigt einen Ätzkanal 15, dessen Endbereich 16 auf dem Niveau der Kavernendecke liegt, also an der Obergrenze des Toleranzbereichs 50. Durch die laterale Erweiterung des Endbereichs 16 des Ätzkanals 15 wurde die Stützstelle 13 zur Kaverne hin geöffnet. Dadurch wurde die Membran 11 frei beweglich. Da die Zugangsöffnung 14 einen rückwärtigen Druckanschluss an die Membran 11 bildet, kann das Sensorelement 10 zur Relativdruckerfassung eingesetzt werden. Außerdem kann das Sensorelement 10 auch als Rückseitendrucksensor für den Einsatz in aggressiven Medien verwendet werden. In diesem Fall muss durch eine geeignete Aufbau- und Verbindungstechnik ein entsprechendes Referenzvakuum auf der Substratvorderseite eingeschlossen werden.

Abschließend sei noch darauf hingewiesen, dass die Zugangsöffnung 14 im Rahmen des erfindungsgemäßen Verfahrens nicht unbedingt mittig im Bereich einer Stützstelle 13 der Membran 11 angeordnet werden muss, sondern auch seitlich beispielsweise im Bereich einer mit der Kaverne verbundenen Stichleitung angeordnet werden kann.

## Patentansprüche

1. Verfahren zur Herstellung eines Bauteils (10) mit mindestens einer in der Bauteiloberfläche ausgebildeten Membran (11), die eine Kaverne (12) überspannt, und mit mindestens einer von der Bauteilrückseite ausgehenden Zugangsöffnung (14) zu der Kaverne (12),
- wobei zumindest eine erste Membranschicht (2) und die Kaverne (12) von der Bauteiloberfläche ausgehend in einem monolithischen Halbleitersubstrat (1) erzeugt werden und
- wobei die Zugangsöffnung (14) von der Bauteilrückseite ausgehend in einem zeitlich begrenzten Ätzprozess erzeugt wird,
**dadurch gekennzeichnet, dass** die Zugangsöffnung (14) in einem Bereich angeordnet wird, in dem das Substratmaterial an die erste Membranschicht (2) heranreicht, und dass der Ätzprozess zum Erzeugen der Zugangsöffnung (14) mindestens einen anisotropen Ätzschritt und mindestens einen isotropen Ätzschritt umfasst, wobei in dem anisotropen Ätzschritt ein von der Substratrückseite ausgehender Ätzkanal (15) erzeugt wird, der unterhalb der ersten Membranschicht (2) in der Umgebung der Kaverne (12) endet, und wobei zumindest der Endbereich (16) dieses Ätzkanals (15) in dem isotropen Ätzschritt aufgeweitet wird, bis der Ätzkanal (15) an die Kaverne angeschlossen ist.

2. Verfahren nach Anspruch 1, **dadurch gekennzeichnet, dass** die Zugangsöffnung im äußeren Randbereich der Kaverne angeordnet wird.

3. Verfahren nach Anspruch 1, **dadurch gekennzeichnet, dass** die Kaverne durch einen Hohlraum gebildet wird, an den sich eine unter der ersten Membranschicht verlaufende Stichleitung anschließt und dass die Zugangsöffnung im Bereich der Stichleitung erzeugt wird.

4. Verfahren nach Anspruch 1, **dadurch gekennzeichnet, dass** die Zugangsöffnung (14) im Bereich einer Stützstelle (13) der Membran (11) innerhalb der Kaverne (12) angeordnet wird.

5. Verfahren nach einem der Ansprüche 1 bis 4, **dadurch gekennzeichnet, dass** in dem Halbleitersubstrat ein erster poröser Schichtbereich erzeugt wird, dass unter dem ersten porösen Schichtbereich ein zweiter poröser Schichtbereich erzeugt wird, wobei die Porosität des zweiten Schichtbereichs größer ist als die Porosität des ersten Schichtbereichs, und dass der zweite Schichtbereich in einem Temperschritt in eine Kaverne umgewandelt wird, während die Poren des ersten Schichtbereichs zumindest weitgehend geschlossen werden, so dass dieser erste Schichtbereich eine erste Membranschicht über der Kaverne bildet.

6. Verfahren nach einem der Ansprüche 1 bis 4, **dadurch gekennzeichnet, dass** in dem Halbleitersubstrat (1) ein poröser Schichtbereich erzeugt wird, dass über dem porösen Schichtbereich eine Epitaxieschicht (2) aus dem Substratmaterial abgeschieden wird und dass der poröse Schichtbereich in einem Temperschritt in eine Kaverne (12) umgewandelt wird, so dass die Epitaxieschicht (2) eine erste Membranschicht über der Kaverne (12) bildet.

7. Verfahren nach einem der Ansprüche 1 bis 4, **dadurch gekennzeichnet, dass** in dem Halbleitersubstrat ein erster Schichtbereich mit einer ersten Dotierung erzeugt wird, dass über diesem ersten Schichtbereich ein vorzugsweise gitterförmiger Stabilisierungsbereich mit mindestens einer Öffnung erzeugt wird, wobei sich die Dotierung des Stabilisierungsbereichs von der des ersten Schichtbereichs unterscheidet, dass der erste Schichtbereich porös geätzt wird, dass über dem Stabilisierungsbereich eine Epitaxieschicht erzeugt wird, und dass der poröse erste Schichtbereich durch eine Temperaturbehandlung in eine Kaverne umgewandelt wird, so dass die Epitaxieschicht eine erste Membranschicht über der Kaverne bildet.

8. Verfahren nach einem der Ansprüche 1 bis 4, **dadurch gekennzeichnet, dass** in dem Halbleitersubstrat ein erster Schichtbereich mit einer ersten Dotierung erzeugt wird, dass über diesem ersten Schichtbereich ein vorzugsweise gitterförmiger Stabilisierungsbereich mit mindestens einer Öffnung erzeugt wird, wobei sich die Dotierung des Stabilisierungsbereichs von der des ersten Schichtbereichs unterscheidet, dass das Halbleitermaterial des ersten Schichtbereichs herausgelöst wird, so dass eine Kaverne unter dem Stabilisierungsbereich entsteht, und dass über dem Stabilisierungsbereich eine Epitaxieschicht erzeugt wird, die eine erste Membranschicht über der Kaverne bildet.

9. Verfahren nach einem der Ansprüche 1 bis 8, **dadurch gekennzeichnet, dass** der Ätzkanal (15) durch Trenchen erzeugt wird.

10. Sensorelement (10) zur Relativdruckmessung
- mit mindestens einer in der Bauteiloberfläche ausgebildeten Membran (11), die einen Schichtaufbau aufweist und eine Kaverne (12) überspannt,
wobei die Membran frei beweglich vorgesehen ist und
- mit mindestens einer von der Bauteilrückseite ausgehenden Zugangsöffnung (14) zu der Kaverne (12),
wobei
- die Kaverne (12) in einem monolithischen Halbleitersubstrat (1) ausgebildet ist und
- zumindest die die Kaverne (12) begrenzende erste Membranschicht (2) aus dem Substratmaterial gebildet ist,
insbesondere hergestellt durch ein Verfahren nach einem der Ansprüche 1 bis 9,
**dadurch gekennzeichnet, dass** die Zugangsöffnung (14) im Bereich einer geöffneten Stützstelle der Membran einen Endbereich aufweist, der innerhalb der Kaverne (12) lateral erweitert ausgebildet ist.

11. Sensorelement (10) zur Relativdruckmessung nach Anspruch 10, mit mindestens einer in der Bauteiloberfläche ausgebildeten Membran (11), die einen Schichtaufbau aufweist und eine Kaverne (12) überspannt, und mit mindestens einer von der Bauteilrückseite ausgehenden Zugangsöffnung (14) zu der Kaverne (12), wobei die Kaverne (12) in einem monolithischen Halbleitersubstrat (1) ausgebildet ist und zumindest die die Kaverne (12) begrenzende erste Membranschicht (2) aus dem Substratmaterial gebildet ist, insbesondere hergestellt durch ein Verfahren nach einem der Ansprüche 1 bis 9,
**dadurch gekennzeichnet, dass** die Mündung der Zugangsöffnung (14) in die Kaverne (12) konkav ausgebildet ist.

12. Sensorelement (10) zur Relativdruckmessung nach Anspruch 11, **dadurch gekennzeichnet dass** die Mündung der Zugangsöffnung unterhalb des Kavernenbodens beginnt.

## Claims

1. Method for producing a component (10) comprising at least one membrane (11) which is formed in the component surface and which spans a cavity (12), and comprising at least one access opening (14) to the cavity (12), said access opening proceeding from the rear side of the component,
- wherein at least one first membrane layer (2) and the cavity (12) are produced in a manner proceeding from the component surface in a monolithic semiconductor substrate (1), and
- wherein the access opening (14) is produced in a manner proceeding from the rear side of the component in a temporally limited etching process,
**characterized in that** the access opening (14) is arranged in a region in which the substrate material extends to the first membrane layer (2), and **in that** the etching process for producing the access opening (14) comprises at least one anisotropic etching step and at least one isotropic etching step, wherein, in the anisotropic etching step, an etching channel (15) proceeding from the rear side of the substrate is produced, said etching channel ending below the first membrane layer (2) in the vicinity of the cavity (12), and wherein at least the end region (16) of said etching channel (15) is widened in the isotropic etching step until the etching channel (15) is connected to the cavity.

2. Method according to Claim 1, **characterized in that** the access opening is arranged in the outer edge region of the cavity.

3. Method according to Claim 1, **characterized in that** the cavity is formed by a hollow space adjoined by a spur line running below the first membrane layer, and **in that** the access opening is produced in the region of the spur line.

4. Method according to Claim 1, **characterized in that** the access opening (14) is arranged in the region of a supporting location (13) of the membrane (11) within the cavity (12).

5. Method according to any of Claims 1 to 4, **characterized in that** a first porous layer region is produced in the semiconductor substrate, **in that** a second porous layer region is produced below the first porous layer region, wherein the porosity of the second layer region is greater than the porosity of the first layer region, and **in that** the second layer region is converted into a cavity in a heat treatment step, while the pores of the first layer region are at least substantially closed, such that said first layer region forms a first membrane layer above the cavity.

6. Method according to any of Claims 1 to 4, **characterized in that** a porous layer region is produced in the semiconductor substrate (1), **in that** an epitaxial layer (2) composed of the substrate material is deposited above the porous layer region, and **in that** the porous layer region is converted into a cavity (12) in a heat treatment step, such that the epitaxial layer (2) forms a first membrane layer above the cavity (12).

7. Method according to any of Claims 1 to 4, **characterized in that** a first layer region having a first doping is produced in the semiconductor substrate, **in that** a preferably latticed stabilization region having at least one opening is produced above said first layer region, wherein the doping of the stabilization region differs from that of the first layer region, **in that** the first layer region is etched in porous fashion, **in that** an epitaxial layer is produced above the stabilization region, and **in that** the porous first layer region is converted into a cavity by means of a thermal treatment, such that the epitaxial layer forms a first membrane layer above the cavity.

8. Method according to any of Claims 1 to 4, **characterized in that** a first layer region having a first doping is produced in the semiconductor substrate, **in that** a preferably latticed stabilization region having at least one opening is produced above said first layer region, wherein the doping of the stabilization region differs from that of the first layer region, **in that** the semiconductor material of the first layer region is removed, such that a cavity arises below the stabilization region, and **in that** an epitaxial layer is produced above the stabilization region, said epitaxial layer forming a first membrane layer above the cavity.

9. Method according to any of Claims 1 to 8, **characterized in that** the etching channel (15) is produced by trenching.

10. Sensor element (10) for relative pressure measurement
- comprising at least one membrane (11) which is formed in the component surface, has a layer construction and spans a cavity (12),
wherein the membrane is provided in freely movable fashion, and
- comprising at least one access opening (14) to the cavity (12), said access opening proceeding from the rear side of the component,
wherein
- the cavity (12) is formed in a monolithic semiconductor substrate (1), and
- at least the first membrane layer (2) delimiting the cavity (12) is formed from the substrate material,
more particularly produced by a method according to any of Claims 1 to 9,
**characterized in that** the access opening (14), in the region of an opened supporting location of the membrane, has an end region that is embodied in laterally extended fashion within the cavity (12).

11. Sensor element (10) for relative pressure measurement according to Claim 10,
comprising at least one membrane (11) which is formed in the component surface, has a layer construction and spans a cavity (12), and comprising at least one access opening (14) to the cavity (12), said access opening proceeding from the rear side of the component, wherein the cavity (12) is formed in a monolithic semiconductor substrate (1), and at least the first membrane layer (2) delimiting the cavity (12) is formed from the substrate material, more particularly produced by a method according to any of Claims 1 to 9,
**characterized in that** the orifice of the access opening (14) into the cavity (12) is embodied in concave fashion.

12. Sensor element (10) for relative pressure measurement according to Claim 11, **characterized in that** the orifice of the access opening begins below the bottom of the cavity.

## Revendications

1. Procédé de fabrication d'un composant (10) comprenant au moins une membrane (11) formée dans la surface du composant, laquelle recouvre une caverne (12), et comprenant au moins une ouverture d'accès (14) vers la caverne (12) à partir du côté arrière du composant,
- au moins une première couche de membrane (2) et la caverne (12) à partir de la surface du composant étant produites dans un substrat en semiconducteur monolithique (1) et
- l'ouverture d'accès (14) à partir du côté arrière du composant étant produite dans un processus de gravure limité sur les côtés,
**caractérisé en ce que** l'ouverture d'accès (14) est disposée dans une zone dans laquelle le matériau du substrat parvient jusque sur la première couche de membrane (2) et **en ce que** le processus de gravure destiné à produire l'ouverture d'accès (14) comprend au moins une étape de gravure anisotrope et au moins une étape de gravure isotrope, un canal de gravure (15) partant du côté arrière du substrat étant produit dans l'étape de gravure anisotrope, lequel se termine sous la première couche de membrane (2) dans l'environnement de la caverne (12), et au moins la zone d'extrémité (16) de ce canal de gravure (15) étant élargie dans l'étape de gravure isotrope jusqu'à ce que le canal de gravure (15) soit raccordé à la caverne.

2. Procédé selon la revendication 1, **caractérisé en ce que** l'ouverture d'accès est disposée dans la zone de bordure extérieure de la caverne.

3. Procédé selon la revendication 1, **caractérisé en ce que** la caverne est formée par un espace creux auquel se raccorde une ligne de dérivation qui s'étend sous la première couche de membrane et **en ce que** l'ouverture d'accès est produite dans la zone de la ligne de dérivation.

4. Procédé selon la revendication 1, **caractérisé en ce que** l'ouverture d'accès (14) est disposée dans la zone d'un point d'appui (13) de la membrane (11) à l'intérieur de la caverne (12).

5. Procédé selon l'une des revendications 1 à 4, **caractérisé en ce qu'**une première zone de couche poreuse est produite dans le substrat en semiconducteur, **en ce qu'**une deuxième zone de couche poreuse est produite sous la première zone de couche poreuse, la porosité de la deuxième zone de couche étant supérieure à la porosité de la première zone de couche, et **en ce que** la deuxième zone de couche est transformée en une caverne dans une étape de mise en température, alors que les pores de la première zone de couche sont au moins pour l'essentiel fermés, de sorte que cette première zone de couche forme une première couche de membrane au-dessus de la caverne.

6. Procédé selon l'une des revendications 1 à 4, **caractérisé en ce qu'**une zone de couche poreuse est produite dans le substrat en semiconducteur (1), **en ce qu'**une couche épitaxiale (2) en le matériau du substrat est déposée sur la zone de couche poreuse et **en ce que** la zone de couche poreuse est transformée en une caverne (12) dans une étape de mise en température, de sorte que la couche épitaxiale (2) forme une première couche de membrane au-dessus de la caverne (12).

7. Procédé selon l'une des revendications 1 à 4, **caractérisé en ce que** dans le substrat en semiconducteur est formée une première zone de couche avec un premier dopage, **en ce qu'**une zone de stabilisation de préférence en forme de grille comprenant au moins une ouverture est produite au-dessus de cette première zone de couche, le dopage de la zone de stabilisation étant différent de celui de la première zone de couche, **en ce que** la première zone de couche est gravée pour être poreuse, **en ce qu'**une couche épitaxiale est produite au-dessus de la zone de stabilisation et **en ce que** la première zone de couche poreuse est transformée en une caverne par un traitement thermique de sorte que la couche épitaxiale forme une première couche de membrane au-dessus de la caverne.

8. Procédé selon l'une des revendications 1 à 4, **caractérisé en ce que** dans le substrat en semiconducteur est formée une première zone de couche avec un premier dopage, **en ce qu'**une zone de stabilisation de préférence en forme de grille comprenant au moins une ouverture est produite au-dessus de cette première zone de couche, le dopage de la zone de stabilisation étant différent de celui de la première zone de couche, **en ce que** le matériau semiconducteur de la première zone de couche est éliminé de sorte qu'il se forme une caverne sous la zone de stabilisation et **en ce qu'**une couche épitaxiale est formée au-dessus de la zone de stabilisation, laquelle forme une première couche de membrane au-dessus de la caverne.

9. Procédé selon l'une des revendications 1 à 8, **caractérisé en ce que** le canal de gravure (15) est produit par creusement.

10. Élément capteur (10) pour la mesure de la pression relative
- comprenant au moins une membrane (11) formée dans la surface du composant, laquelle présente une structure de couche et recouvre une caverne (12), la membrane étant prévue pour pouvoir se déplacer librement et
- comprenant au moins une ouverture d'accès (14) vers la caverne (12) à partir du côté arrière du composant,
- la caverne (12) étant formée dans un substrat en semiconducteur monolithique (1) et
- au moins la première couche de membrane (2) qui délimite la caverne (12) étant réalisée dans le matériau du substrat,
notamment fabriqué par un procédé selon l'une des revendications 1 à 9,
**caractérisé en ce que** l'ouverture d'accès (14) présente dans la zone d'un point d'appui ouvert de la membrane une zone d'extrémité qui est configurée élargie latéralement à l'intérieur de la caverne (12).

11. Élément capteur (10) pour la mesure de la pression relative selon la revendication 10, comprenant au moins une membrane (11) formée dans la surface du composant, laquelle présente une structure de couche et recouvre une caverne (12), et comprenant au moins une ouverture d'accès (14) vers la caverne (12) à partir du côté arrière du composant, la caverne (12) étant formée dans un substrat en semiconducteur monolithique (1) et au moins la première couche de membrane (2) qui délimite la caverne (12) étant réalisée dans le matériau du substrat,
notamment fabriqué par un procédé selon l'une des revendications 1 à 9,
**caractérisé en ce que** le débouché de l'ouverture d'accès (14) dans la caverne (12) est réalisé en forme concave.

12. Élément capteur (10) pour la mesure de la pression relative selon la revendication 11, **caractérisé en ce que** le débouché de l'ouverture d'accès commence au-dessous du fond de la caverne.
